# EUROPEAN PATENT APPLICATION

(11) **EP 4 481 826 A1**
(43) Date of publication of application: **25.12.2024**
(21) Application number: 23756099.0
(22) Date of filing: 23.01.2023
(51) Int. Cl.: H01L 27/146

(54) **FUNCTIONAL ELEMENT AND MANUFACTURING METHOD OF SAME**

(30) Priority: 18.02.2022 JP 2022023771
(71) Applicant: Panasonic Intellectual Property Management Co., Ltd., Kadoma-shi, Osaka 571-0057 (JP)
(72) Inventor: YAMAOKA, Yoshikazu, Kadoma-shi, Osaka 571-0057 (JP); MACHIDA, Shinichi, Kadoma-shi, Osaka 571-0057 (JP); SHISHIDO, Sanshiro, Kadoma-shi, Osaka 571-0057 (JP)
(74) Representative: Grünecker Patent- und Rechtsanwälte PartG mbB
(86) International application number: PCT/JP2023/001942
(87) International publication number: WO 2023/157571

(57) **Abstract**

A method for manufacturing a functional element includes: preparing a substrate at an upper surface of which a first electrode and a second electrode are exposed; forming a first film above the substrate, the first film being provided with a gap where at least part of an upper surface of the first electrode is exposed; forming a second film on the first electrode, the second electrode, and the first film using a coating method; exposing the upper surface of the first electrode by removing a portion of the second film that is on the first electrode; and forming an electric contact 15 on the upper surface of the first electrode.

## Description

### Technical Field

The present disclosure relates to a functional element and a method for manufacturing the same.

### Background Art

Studies have been actively conducted on a photoelectric conversion element using a photoelectric conversion layer containing a photoelectric conversion material. For example, a semiconductor material, such as quantum dots using the quantum size effect, is used as a photoelectric conversion material contained in a photoelectric conversion layer.

For example, in a functional element such as the photoelectric conversion element, a substrate where an electrode that collects charges generated by the photoelectric conversion layer and an electrode for controlling voltage to be applied to the photoelectric conversion layer are exposed at the surface thereof is used. A functional layer including a photoelectric conversion layer is laminated by formation of a film of a semiconductor material on the substrate by using a coating method such as spin coating. Then, the functional layer on the electrode for controlling voltage to be applied to the photoelectric conversion layer is removed to expose the electrode, and a conductive layer to be connected to the functional layer is formed on the electrode, thereby enabling control voltage to be applied to the photoelectric conversion layer.

For example, PTL 1 discloses an imaging device as a functional element manufactured using the above-described method.

### Citation List

### Patent Literature

PTL 1: International Publication No. WO2019/239851

### Non Patent Literature

NPL 1: Patrick R. Brown et al., "Energy Level Modification in Lead Sulfide Quantum Dot Thin Films through Ligand Exchange", ACS Nano, American Chemical Society, 2014, Vol. 8, No. 6, pp 5863 - 5872

### Summary of Invention

### Technical Problem

However, functional elements and methods for manufacturing them in the related art have room for improvement in terms of yield. The present disclosure aims to provide a functional element and a method for manufacturing the same with which yield can be improved.

### Solution to Problem

A method for manufacturing a functional element according to one aspect of the present disclosure includes preparing a substrate at an upper surface of which a first electrode and a second electrode are exposed; forming a first film above the substrate, the first film being provided with a gap where at least part of an upper surface of the first electrode is exposed; forming a second film on the first electrode, the second electrode, and the first film using a coating method; exposing the at least part of the upper surface of the first electrode by removing a portion of the second film that is on the first electrode; and forming an electric contact on the first electrode.

A functional element according to one aspect of the present disclosure includes a substrate; a first electrode provided at an upper surface of the substrate; at least one second electrode provided at the upper surface of the substrate; a first film located above the substrate and provided with a gap overlapping at least part of an upper surface of the first electrode in top view; a functional layer located on the at least one second electrode; a third electrode located on the functional layer; and an electric contact connected to the first electrode through the gap of the first film and electrically connecting the first electrode and the third electrode. The height of a surface of the first film from the upper surface of the substrate is lower than the height of a surface of the functional film from the upper surface of the substrate.

### Advantageous Effects of Invention

According to one aspect of the present disclosure, yield can be improved.

### Brief Description of Drawings

[Fig. 1] Fig. 1 is a sectional view of a photoelectric conversion element according to an embodiment.
[Fig. 2A] Fig. 2A is a plan view illustrating an example of the top-view shape of a first electrode according to the embodiment.
[Fig. 2B] Fig. 2B is a plan view illustrating an example of the top-view shape of a patterned film formed on the first electrode according to the embodiment.
[Fig. 2C] Fig. 2C is a plan view illustrating another example of the top-view shape of the patterned film formed on the first electrode according to the embodiment.
[Fig. 2D] Fig. 2D is a plan view illustrating yet another example of the top-view shape of the patterned film formed on the first electrode according to the embodiment.
[Fig. 3A] Fig. 3A is a sectional view illustrating another example of the layout of the patterned film according to the embodiment.
[Fig. 3B] Fig. 3B is a sectional view illustrating yet another example of the layout of the patterned film according to the embodiment.
[Fig. 4] Fig. 4 is a flowchart of a method for manufacturing a photoelectric conversion element according to the embodiment.
[Fig. 5] Fig. 5 is a diagram illustrating a step of preparing a substrate according to the embodiment.
[Fig. 6A] Fig. 6A is a diagram illustrating an example of a step of forming the patterned film according to the embodiment.
[Fig. 6B] Fig. 6B is a diagram illustrating the example of the step of forming the patterned film according to the embodiment.
[Fig. 6C] Fig. 6C is a diagram illustrating the example of the step of forming the patterned film according to the embodiment.
[Fig. 6D] Fig. 6D is a diagram illustrating the example of the step of forming the patterned film according to the embodiment.
[Fig. 7A] Fig. 7A is a diagram illustrating another example of the step of forming the patterned film according to the embodiment.
[Fig. 7B] Fig. 7B is a diagram illustrating the other example of the step of forming the patterned film according to the embodiment.
[Fig. 8] Fig. 8 is a diagram illustrating a step of forming a functional layer and a step of forming a third electrode according to the embodiment.
[Fig. 9A] Fig. 9A is a diagram illustrating a step of removing the functional layer according to the embodiment.
[Fig. 9B] Fig. 9B is a diagram illustrating the step of removing the functional layer according to the embodiment.
[Fig. 10] Fig. 10 is a diagram illustrating a step of forming an electric contact according to the embodiment.
[Fig. 11] Fig. 11 is a sectional view of the photoelectric conversion element according to a modification of the embodiment.
[Fig. 12] Fig. 12 is a top perspective view of the photoelectric conversion element according to the modification of the embodiment.
[Fig. 13] Fig. 13 is a diagram illustrating an example of the circuit configuration of an imaging device according to the embodiment.
[Fig. 14] Fig. 14 is a sectional view schematically illustrating the device structure of a pixel in the imaging device according to the embodiment.

### Description of Embodiments

### (Outline of the Present Disclosure)

A method for manufacturing a functional element according to one aspect of the present disclosure includes: preparing a substrate at an upper surface of which a first electrode and a second electrode are exposed; forming a first film above the substrate, the first film being provided with a gap where at least part of an upper surface of the first electrode is exposed; forming a second film on the first electrode, the second electrode, and the first film using a coating method; exposing the at least part of the upper surface of the first electrode by removing a portion of the second film that is on the first electrode; and forming an electric contact on the first electrode.

Because the first film provided with the gap on the first electrode is formed, the second film formed using a coating method fills the gap of the first film on the first electrode and becomes thick. This reduces a possibility that, in the step of removing the portion of the second film that is on the first electrode, the first electrode is also removed and the first electrode 1 diminishes or disappears. This consequently reduces connection failure between the first electrode and the electric contact. Thus, yield of the functional element manufactured can be improved.

Also, for example, the coating method may be spin coating. More specifically, in the forming of the second film, the second film may be formed using spin coating as the coating method.

In a case where the second film is formed using spin coating, the film thickness tends to vary particularly due to unevenness of the surface where the second film is to be formed, but the second film filling the gap of the first film inhibits the first electrode from diminishing or disappearing even if spin coating is used to form the second film.

Also, for example, in the forming of the first film, the first film may be formed to cover part of the first electrode.

The first film covering the first electrode makes it easier for the height, from the substrate, of the upper surface of the first film to be higher, which makes the second film to be formed more thickly on the first electrode.

Also, for example, the gap may be at least one opening. More specifically, in the forming of the first film, the first film provided with at least one opening as the gap may be formed.

Because the gap is thus an opening, the second film tends not to overflow from the opening in the formation of the second film, which makes the second film to be formed more thickly on the first electrode.

Also, for example, the at least one opening may include a plurality of openings. More specifically, in the forming of the first film, the first film provided with a plurality of openings may be formed.

This allows each of the plurality of openings to be reduced in size and thus makes it easier for the second film to fill each of the plurality of openings. Thus, the second film can be formed more thickly on the first electrode.

Also, for example, the removing of the portion of the second film that is on the first electrode may include removing the portion of the second film by etching using a halogen-based gas.

Thus, the second film fills the gap of the first film and becomes thick on the first electrode even in a case of using a halogen-based gas, which has high removal power, and this inhibits the first electrode from diminishing or disappearing due to over-etching.

Also, for example, the portion of the second film that is on the first electrode may include a first portion and a second portion, and the removing of the portion of the second film that is on the first electrode may include removing the first portion and removing the second portion unremoved in the removing of the first portion.

Performing etching to leave part of the second film on the first electrode in this way inhibits the first electrode from diminishing or disappearing due to over-etching.

Also, a functional element according to one aspect of the present disclosure includes a substrate; a first electrode provided at an upper surface of the substrate; at least one second electrode provided at the upper surface of the substrate; a first film located above the substrate and provided with a gap overlapping at least part of an upper surface of the first electrode in top view; a functional layer located on the at least one second electrode; a third electrode located on the functional layer; and an electric contact connected to the first electrode through the gap of the first film and electrically connecting the first electrode and the third electrode. The height of a surface of the first film from the upper surface of the substrate is lower than the height of a surface of the functional film from the upper surface of the substrate.

Thus, the first electrode is protected by the first film provided with the gap by being disposed to sandwich the first electrode. For example, in the event of removing the functional layer temporarily formed on the first electrode during manufacture, the functional layer on the first electrode is formed thickly owing to the gap of the first film, which inhibits the first electrode from being removed and diminishing or disappearing. This reduces connection failure between the first electrode and the electric contact. Thus, yield of the functional element can be improved. Further, even if the first electrode is etched during the removal of the functional layer, a portion immediately below the first film is protected from etching. Thus, there is connection between the side surface of the remaining first electrode and the electric contact, which reduces connection failure.

Also, for example, the first film may cover part of the first electrode.

Thus, for example, in the removal of the functional layer temporarily formed on the first electrode during manufacture, the first film covering the first electrode makes it easier for the height, from the substrate, of the upper surface of the first film higher, which allows the second film to be formed more thickly on the first electrode.

Also, for example, the gap may be at least one opening. More specifically, the first film may be provided with at least one opening as the gap.

Thus, for example, in the removal of the functional layer temporarily formed on the first electrode during manufacture, the gap of the first film makes it easier for the functional layer on the first electrode to be formed more thickly.

Also, for example, the at least one opening may include a plurality of openings. More specifically, the first film may be provided with a plurality of openings.

This makes each of the plurality of openings small, and for example, in the removal of the functional layer temporarily formed on the first electrode during manufacture, the gap of the first film makes it easier for the functional layer on the first electrode to be formed more thickly.

Also, for example, the functional element may be a photoelectric conversion element, and the functional layer may include a photoelectric conversion layer.

Thus, a photoelectric conversion element with improved yield can be achieved.

Also, for example, the functional element may be an imaging device, the at least one second electrode may include a plurality of second electrodes, the functional layer may include a photoelectric conversion layer, and the plurality of second electrodes may be a plurality of pixel electrodes spaced away from one another.

This makes it possible to achieve an imaging device with improved yield.

Also, for example, the first film may cover the upper surface of the substrate at a region between two adjacent pixel electrodes of the plurality of pixel electrodes.

Thus, the first film is disposed between adjacent ones of the pixel electrodes as well. Thus, the first film reduces charge migration between adjacent ones of the pixel electrodes even if there is a potential difference between adjacent pixels due to a difference between their amounts of charges collected. This reduces mixing of colors between the adjacent pixels. Because the first film can also be used to reduce mixing of colors between adjacent pixels, yield can be improved for an imaging device with higher performance.

Also, for example, the photoelectric conversion layer may contain a colloidal quantum dot.

Because the photoelectric conversion layer thus contains colloidal quantum dots, for example, in the removal of the functional layer temporarily formed on the first electrode during manufacture, a halogen-based gas is used to perform etching with high removal power. Even in such a case, the functional layer being thickly formed on the first electrode inhibits the first electrode from diminishing or disappearing due to over-etching.

Embodiments of the present disclosure are described below with reference to the drawings.

Note that the embodiments described below all show comprehensive or specific examples. Numerical values, shapes, constituents, the arrangement, positions, and modes of connection of the constituents, steps, the order of the steps, and the like are examples and are not provided with an intention to limit the present disclosure. Also, of the constituents in the present embodiments below, constituents not described in independent claims are described as optional constituents. Also, the drawings are not necessarily depicted accurately. Thus, for example, scales and the like are not necessarily consistent throughout the drawings. Also, in the drawings, configurations that are substantially the same are denoted by the same reference numeral, and overlapping descriptions may be omitted or simplified.

Also, a term indicating the relation between elements, a term indicating the shape of an element, and a range of numerical values herein are not expressions representing only the strict meanings, but expressions meaning a substantially equivalent range, i.e., including, e.g., a difference of a small percentage.

Also, terms such as "above" and "under" herein do not refer to an upward direction (upward vertically) and a downward direction (downward vertically) in absolute space recognition, but are used as terms defined by relative positional relations based on the order of layers in a multilayer configuration. Note that terms such as "above" and "under" are used only to specify the positions of members relative to each other and are not intended to limit the posture of an imaging device during use. Also, terms "above" and "under" are used not only when two constituents are disposed away from each other with another constituent being present between the two constituents, but also when two constituents are disposed close to each other and in contact with each other. The direction herein in which a functional layer and the like are laminated at the substrate is an upward direction.

Also, an x-axis, a y-axis, and a z-axis herein and in the drawings represent the three axes of the three-dimensional orthogonal coordinate system. The x-axis and the y-axis are a row direction and a column direction, respectively, in a case where second electrodes are arranged in rows and in columns. The z-axis is a lamination direction in which the functional layer and the like are laminated at a substrate. The positive side of the z-axis direction herein is "above", and the negative side of the z-axis direction herein is "under". Also, "top view" herein is, unless otherwise noted, the view seen from the positive side of the z-axis direction.

Also, ordinal numbers such as "first" and "second" are used herein to distinguish constituents of the same kind to avoid confusion, not to specify the number or order of the constituents, unless otherwise noted.

Also, electromagnetic waves in general, including visible light, infrared rays, and ultraviolet rays, are expressed herein as "light" for convenience.

### (Embodiment)

A photoelectric conversion element and an imaging device including the photoelectric conversion element according to the present embodiment are described below.

### [Configuration of the Photoelectric Conversion Element]

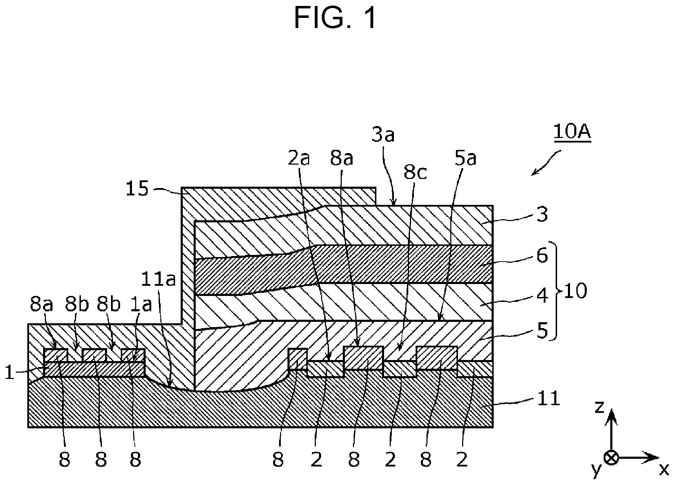

First, a description is given of the configuration of a photoelectric conversion element included in an imaging device according to the embodiment. Fig. 1 is a sectional view of a photoelectric conversion element 10A according to the present embodiment. Note that Fig. 1 illustrates part of the photoelectric conversion element 10A. Specifically, Fig. 1 is a diagram illustrating a region of the photoelectric conversion element 10A where a first electrode 1 and part of a plurality of second electrodes 2 are provided at a substrate 11. A specific configuration of the imaging device including the photoelectric conversion element 10A illustrated in Fig. 1 will be described later.

As illustrated in Fig. 1, the photoelectric conversion element 10A includes the substrate 11, the first electrode 1, the second electrodes 2, a third electrode 3, a functional layer 10 located between the third electrode 3 and the second electrodes 2, a patterned film 8, and an electric contact 15 electrically connecting the first electrode 1 and the third electrode 3. The functional layer 10 includes a photoelectric conversion layer 4, an electron blocking layer 5 located between the second electrodes 2 and the photoelectric conversion layer 4, and a hole blocking layer 6 located between the third electrode 3 and the photoelectric conversion layer 4. In the photoelectric conversion element 10A, the second electrodes 2, the electron blocking layer 5, the photoelectric conversion layer 4, the hole blocking layer 6, and the third electrode 3 are laminated in this order at an upper surface 1 1a of the substrate 11.

The substrate 11 is, for example, an ROIC (ReadOut Integrated Circuit) substrate. Fig. 1 illustrates an insulating layer of the substrate 11, which is an upper part of the substrate 11, and omits depiction of the structure of a lower part thereof. Circuits and the like for operating the photoelectric conversion element 10A are formed on the substrate 11 and inside the substrate 11. For example, the substrate 11 includes, under the insulating layer, a semiconductor layer where transistors and the like are formed. The insulating layer has a single-layer structure or a multi-layer structure of, for example, a silicon oxide film, a silicon nitride film, a TEOS (tetraethyl orthosilicate) film, or the like, but is not limited to a particular structure. Note that the substrate 11 is not limited to any particular type, and any of various kinds of substrates other than a ROIC substrate, such as a wiring substrate, can be used as the substrate 11.

The first electrode 1, the second electrodes 2, and the third electrode 3 are, for example, film-shaped electrodes.

The first electrode 1 is a power-feeding terminal for feeding power to the third electrode 3. The first electrode 1 is, for example, a control electrode for applying control voltage to the functional layer 10. The first electrode 1 is provided at the upper surface 11a of the substrate 11. An upper surface 1a of the first electrode 1 is located at a level above the upper surface 11a of the substrate 11, or specifically at a level above the upper surface 11a around the first electrode 1. In other words, in the lamination direction, the height of the upper surface 1a of the first electrode 1 is higher than the upper surface 11a of the substrate 11. Thus, the first electrode 1 forms a projecting shape at the substrate 11 where the first electrode 1 is provided. Also, the substrate 11 too forms a projecting shape at the location where the first electrode 1 is formed.

The first electrode 1 is disposed at the substrate 11 at a region different from a region where the plurality of second electrodes 2 are provided. Also, the first electrode 1 is disposed surrounding a region where the functional layer 10 is provided. In other words, the first electrode 1 does not overlap the functional layer 10 in top view. Although there is a single first electrode 1 in the example illustrated in Fig. 1, it is to be noted that there may be two or more first electrodes 1. In a case where two or more first electrodes 1 are disposed, for example, they are disposed to sandwich or surround the functional layer 10. Wiring, a plug, or the like (not shown) for supplying voltage is connected to the first electrode 1.

At least part of the upper surface 1a of the first electrode 1 is in contact with the electric contact 15. The first electrode 1 is electrically connected to the third electrode 3 via the electric contact 15.

As a material for the first electrode 1, a conductive material such as Al, Cu, Ti, TiN, Ta, TaN, Mo, Ru, In, Mg, Ag, Au, or Pt is used.

The thickness of the first electrode 1 is, for example, greater than or equal to 10 nm and smaller than or equal to 200 nm.

The second electrodes 2 are an electrode layer for capturing charges generated by the photoelectric conversion layer 4. The second electrodes 2 are pixel electrodes in a case where the photoelectric conversion element 10A is used for an imaging device. The second electrodes 2 are provided at the upper surface 11a of the substrate 11. Upper surfaces 2a of the second electrodes 2 are located at a level above the upper surface 11a of the substrate 11 or specifically the upper surface 11a of the substrate 11 around the second electrodes 2. In other words, in the lamination direction, the height of the upper surfaces 2a of the second electrodes 2 is higher than the upper surface 1 1a of the substrate 11.

For example, the plurality of second electrodes 2 are provided at a region of the substrate 11 where the functional layer 10 is provided. In other words, the plurality of second electrodes 2 overlap the functional layer 10 in top view. The plurality of second electrodes 2 are, for example, disposed on the substrate 11, arranged in rows and columns. The plurality of second electrodes 2 are spaced away from one another, with the insulating layer of the substrate 11 being disposed in between the plurality of second electrodes 2 spaced away from one another. The distance between adjacent ones of the second electrodes 2 is, for example, approximately 1 µm. Note that the number of second electrodes 2 is not limited to a particular number. The number of second electrodes 2 may be one. Wiring, a plug, or the like (not shown) for voltage supply is connected to each second electrode 2.

The distance between adjacent ones of the second electrodes 2 is, for example, shorter than the distance between the first electrode 1 and the second electrode 2 closest to the first electrode 1.

The thickness of the second electrodes 2 is, for example, greater than or equal to 10 nm and smaller than or equal to 200 nm. Also, the width of the second electrodes 2 is, for example, greater than or equal to 0.5 µm and smaller than or equal to 10 µm.

The third electrode 3 is an electrode layer provided opposite the second electrodes 2 with the functional layer 10 interposed in between. The third electrode 3 is located on the functional layer 10. The third electrode 3 collects charges with the opposite polarity from that of the charges collected by the second electrodes 2. A predetermined voltage is applied to the third electrode 3 via the first electrode 1 and the electric contact 15. As a result of this, a predetermined bias voltage is applied to the second electrodes 2 and the third electrode 3. The application of the bias voltage enables the second electrodes 2 to collect charges which are either holes or electrons of hole-electron pairs generated in the photoelectric conversion layer 4 by photoelectric conversion. The charges collected by the second electrodes 2 are used as, for example, signal charges. If, for example, holes are used as the signal charges, the bias voltage is applied to the second electrodes 2 so that the potential of the third electrode 3 may be positive. Then, holes are collected by the second electrodes 2, and electrons are collected by the third electrode 3. Also, when the work function of the third electrode 3 is smaller than that of the second electrodes 2, under the condition that the potential of the third electrode 3 is zero or negative in relation to the second electrodes 2, the second electrodes 2 may collect holes, and the third electrode 3 may collect electrons. In the case described below, the second electrodes 2 collect holes as signal charges. Note that in a case where electrons are used as signal charges, a bias voltage to make the potential of the third electrode 3 negative is applied to the second electrodes 2. Also, when the work function of the third electrode 3 is larger than that of the second electrodes 2, under the condition that the potential of the third electrode 3 is zero or positive in relation to the second electrodes 2, the second electrodes 2 may collect electrons, and the third electrode 3 may collect holes.

The third electrode 3 is, for example, a transparent electrode having a high light-transmitting property for a desired wavelength range. A desired wavelength range includes, for example, a wavelength of light photoelectrically converted by the photoelectric conversion layer 4. In a case where the photoelectric conversion layer 4 includes colloidal quantum dots, the desired wavelength range is, for example, a wavelength range including the absorption peak wavelength of a colloidal quantum dot. Also, having a high light-transmitting property for a certain wavelength herein means that the light transmittance is 50% or higher for the certain wavelength or may mean that the light transmittance is 80% or higher for the certain wavelength.

A material used as the transparent electrode is, for example, transparent conducting oxide (TCO) with a small resistance value. There is no particular limitation as to the TCO, but for example, ITO, IZO (InZnO; Indium Zinc Oxide), AZO (AlZnO: Aluminum Zinc Oxide), FTO (Fluorine-doped Tin Oxide), SnO₂, TiO₂, ZnO, or the like can be used. Also, graphene, a carbon nanotube, or the like may be used as a material for the transparent electrode.

The thickness of the third electrode 3 is, for example, greater than or equal to 10 nm and smaller than or equal to 200 nm.

The patterned film 8 is an example of a first film and is a protective film having a predetermined pattern. The patterned film 8 is located above the substrate 11. An upper surface 8a of the patterned film 8 is located at a level above the first electrode 1 and the second electrodes 2. Also, in the lamination direction, the height of the upper surface 8a of the patterned film 8 is, for example, lower than the height of an upper surface 5a of the electron blocking layer 5, which is the lowermost layer of the functional layer 10. The thickness of the patterned film 8 is, for example, greater than or equal to 1 nm and smaller than or equal to 200 nm. Note that the height of the upper surface 8a of the patterned film 8 may be higher than the height of the upper surface 5a of the electron blocking layer 5.

The patterned film 8 is disposed at, for example, a region on the substrate 11 where the first electrode 1 is provided and a region on the substrate 11 where the plurality of second electrodes 2 are provided. The region where the first electrode 1 is provided is, for example, a region not overlapping the functional layer 10 in top view. The region where the plurality of second electrodes 2 are provided is, for example, a region overlapping the functional layer 10 in top view. Note that the patterned film 8 does not have to be disposed at the region where the second electrodes are provided.

The patterned film 8 is disposed to sandwich the first electrode 1 without interposition of the second electrodes 2 in top view and is thus provided with a gap 8b overlapping at least part of the upper surface 1a of the first electrode 1. In top view, the gap 8b does not overlap the upper surfaces 2a of the second electrodes 2. For example, the patterned film 8 is provided with a plurality of gaps 8b. Also, the patterned film 8 covers part of the upper surface of the first electrode 1. For example, the patterned film 8 covers two opposing locations out of the edge portions of the upper surface of the first electrode 1. The formation of such a patterned film 8 reduces a possibility that, in the process of manufacturing the photoelectric conversion element 10A, the first electrode 1 diminishes or disappears by being overly etched. Details of the advantageous effects will be described later.

The electric contact 15 extends through the gaps 8b, and the patterned film 8 around the gaps 8b is covered by the electric contact 15.

The width (e.g., the shortest width) of the gaps 8b is, for example, greater than or equal to 0.1 µm and smaller than or equal to 100 µm or may be greater than or equal to 1 µm and smaller than or equal to 10 µm. Also, the width of the gaps 8b is, for example, higher than or equal to 2% and lower than or equal to 110% of the width of the first electrode 1.

The patterned film 8 covers part of the first electrode 1. In the example illustrated in Fig. 1, the patterned film 8 covers the upper surface 1a of the first electrode 1 while in contact therewith. Note that the patterned film 8 does not have to cover the first electrode 1. For example, the patterned film 8 may be formed on the substrate 11 in the vicinities of the first electrode 1 in top view. The vicinities represent, for example, a range smaller than or equal to the distance between adjacent ones of the second electrodes 2.

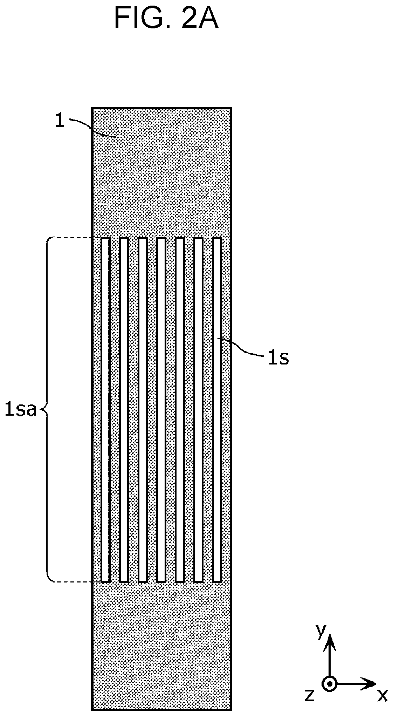

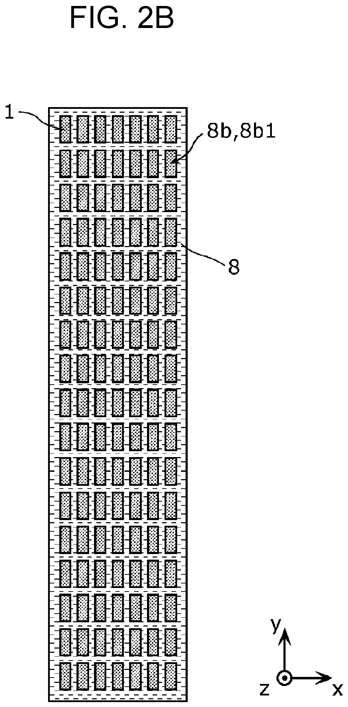

Here, using Figs. 2A to 2D, details are described of the top-view shape of the patterned film 8 provided at the region where the first electrode 1 is formed. Fig. 2A is a plan view illustrating an example of the top-view shape of the first electrode 1. Figs. 2B to 2D are plan views illustrating examples of the top-view shape of the patterned film 8 formed on the first electrode 1. Note that although the first electrode 1 and the patterned film 8 are textured in Figs. 2A to 2D for visibility, it does not mean that the upper surfaces of the first electrode 1 and the patterned film 8 are textured.

As illustrated in Fig. 2A, the outside shape of the first electrode 1 in top view is, for example, an elongated rectangle. The length of the rectangle in the short-side direction is, for example, about 100 µm. Also, the length of the rectangle in the long-side direction is, for example, several millimeters. For example, in top view, the first electrode 1 has a striped region 1sa where a plurality of slits 1s are formed. Note that the shape and size of the first electrode 1 in top view are not limited to any particular ones. The slits 1s do not have to be formed in the first electrode 1.

As illustrated in Fig. 2B, the patterned film 8 is provided with, for example, a plurality of openings 8b 1 as the plurality of gaps 8b. For example, the plurality of openings 8b1 are disposed in rows and columns on the first electrode 1. This enhances the functionality of the patterned film 8 to protect the first electrode 1 during etching.

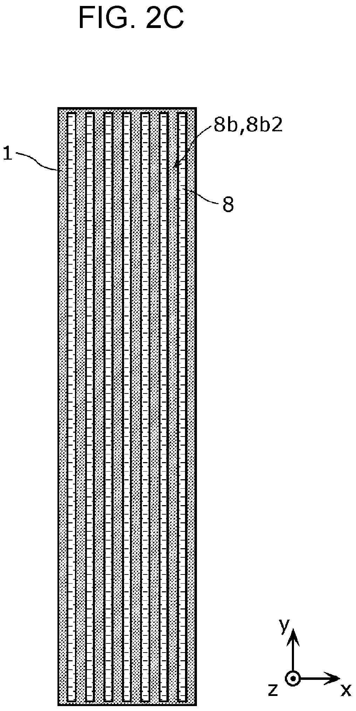

Also, as illustrated in Fig. 2C, the patterned film 8 may be provided with a plurality of slits 8b2 in stripes as the plurality of the gaps 8b.

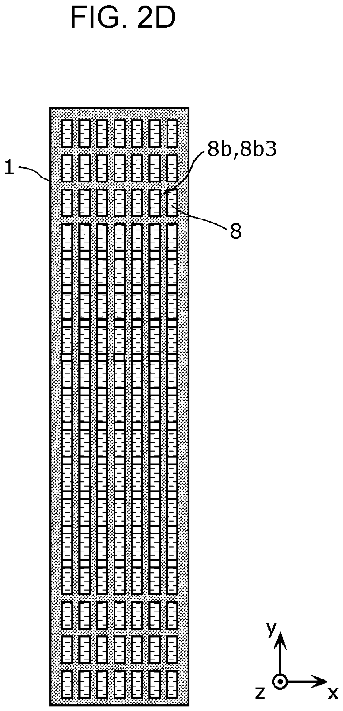

Also, as illustrated in Fig. 2D, the patterned film 8 may be provided with grid-shaped slits 8b3 as the gaps 8b.

Also, for example, in the striped region 1sa of the first electrode 1, the patterned film 8 is disposed at positions overlapping the slits 1s, and at least part of the gaps 8b overlaps the first electrode 1 in the region 1sa.

Referring back to Fig. 1, the patterned film 8 is also located between the substrate 11 and the functional layer 10. The patterned film 8 covers, while in contact with, the upper surface 11a of the substrate 11 at a region between adjacent ones of the second electrodes 2. The patterned film 8 is disposed to sandwich each second electrode 2 of the plurality of second electrodes 2 in top view. Thus, the patterned film 8 is provided with a gap 8c overlapping at least part of one second electrode 2 in top view. The functional layer 10 (or specifically the electron blocking layer 5) is connected to the second electrodes 2 through the gaps 8c. The functional layer 10 (or specifically the electron blocking layer 5) covers the patterned film 8 around the gaps 8c. The patterned film 8 is in contact with the side surfaces of the second electrodes 2 and completely fills in between adjacent ones of the second electrodes 2 on the substrate 11. Note that a portion of the patterned film 8 that covers the upper surface 11a of the substrate 11 between adjacent ones of the second electrodes 2 may be spaced away from the side surfaces of the second electrodes 2.

Because the patterned film 8 is disposed in such a manner, the patterned film 8 reduces charge migration between adjacent ones of the second electrodes 2. Specifically, the plurality of second electrodes 2 may have different potentials from one another depending on the amount of charges collected. For example, the second electrode 2 at a region on which a large amount of light falls incident collects more charges, while the second electrode 2 at a region on which a small amount of light falls incident collects fewer charges. This generates a potential difference between such two second electrodes 2, and in a case where charges collected are holes, holes migrate from the second electrode 2 with a higher potential to the second electrode 2 with a lower potential via the functional layer 10. As a result, in a case of an imaging device, mixing of colors occurs between adjacent pixels, causing blur at the edge of an image. The presence of the patterned film 8 covering the upper surface 11a of the substrate 11 between adjacent second electrodes 2 makes the distance of charge migration between the adjacent second electrodes 2 via the functional layer 10 longer and thus reduces such charge migration.

Also, in the example illustrated in Fig. 1, the upper surfaces 2a of the second electrodes 2 are not covered by the patterned film 8. Thus, the capturing of charges by the second electrodes 2 is not hindered by the patterned film 8, which reduces lowering of the charge capturing efficiency.

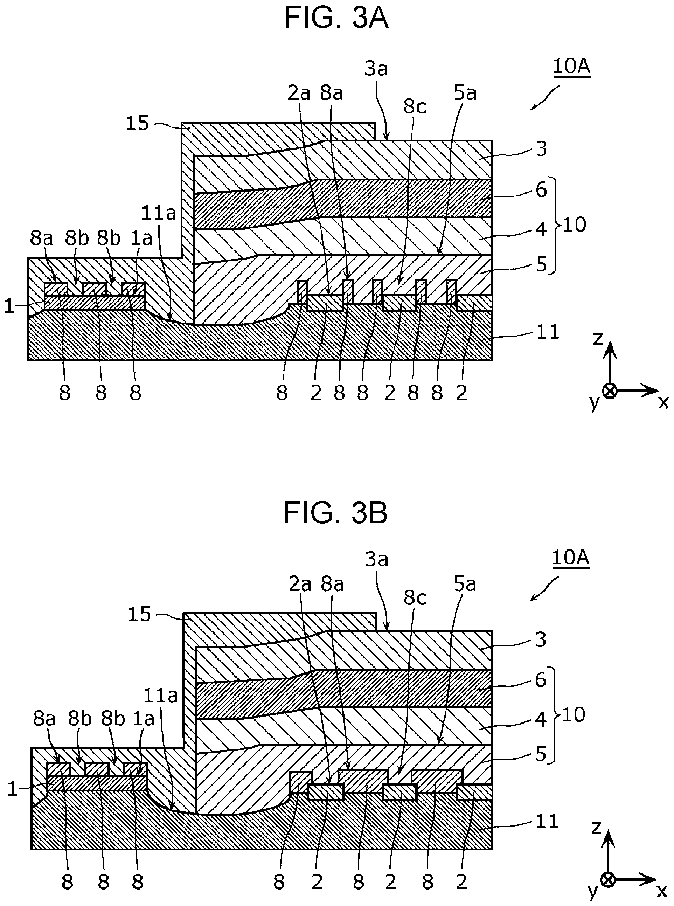

Note that the layout of the patterned film 8 for reducing charge migration between the second electrodes 2 is not limited to the example illustrated in Fig. 1. Figs. 3A and 3B are sectional views illustrating another example of the layout of the patterned film 8.

As illustrated in Fig. 3A, the patterned film 8 is disposed to sandwich each second electrode 2 of the plurality of second electrodes 2 in top view. Also, unlike the example illustrated in Fig. 1, the patterned film 8 illustrated in Fig. 3A does not completely fill in between adjacent ones of the second electrodes 2. The patterned film 8 may be divided into two or more parts between adjacent ones of the second electrodes 2.

Also, as illustrated in Fig. 3B, the patterned film 8 may cover, while in contact with, the end portions of the upper surfaces 2a of adj acent ones of the second electrodes 2. The charge migration reducing effect can be enhanced especially when the patterned film 8 covers the end portions of the second electrodes 2, where electric fields tend to concentrate.

An insulating material is used as a material for the patterned film 8. Examples of the insulating material include silicon oxide, silicon nitride, tantalum oxide, and titanium oxide. Also, a negative photoresist or a negative electron beam resist may be used as the insulating material.

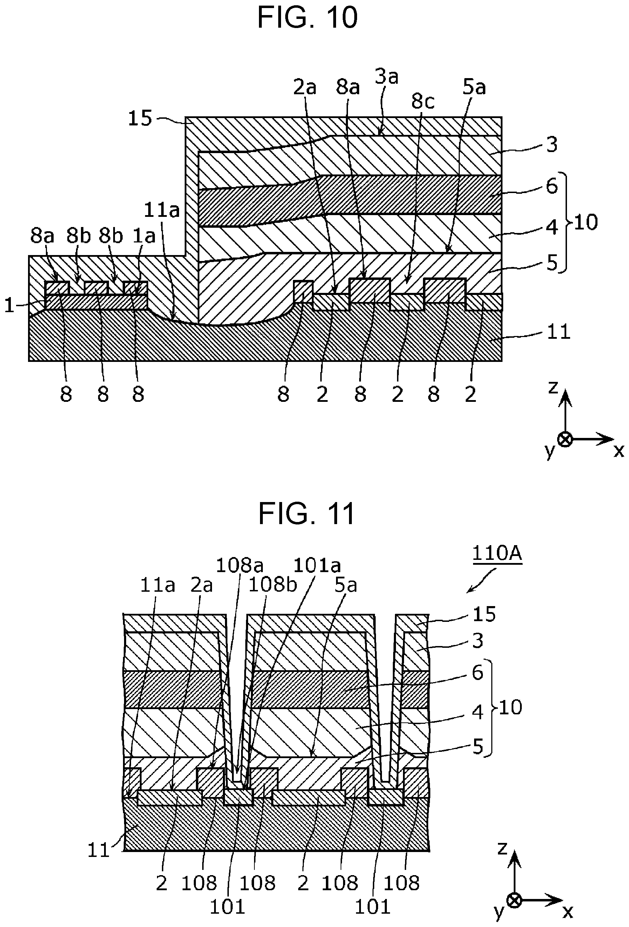

Referring back to Fig. 1, the electric contact 15 is a conductive layer electrically connecting the first electrode 1 and the third electrode 3. The electric contact 15 is connected to the first electrode 1 through the gaps 8b. Also, the electric contact 15 covers the side surface of the functional layer 10 and is connected to an upper surface 3a of the third electrode 3. In the example illustrated in Fig. 1, the electric contact 15 covers part of the upper surface 3a. If the electric contact 15 has a high light-transmitting property, the electric contact 15 may cover, for example, the entire upper surface 3a as illustrated in Fig. 10 to be described later.

The materials listed earlier as a material for the transparent electrode can be used as a material for the electric contact 15. Also, a conductive material such as Al, Cu, Ti, TiN, Ta, TaN, Mo, Ru, In, Mg, Ag, Au, or Pt may be used as a material for the electric contact 15. Note that the third electrode 3 and the electric contact 15 may be configured by a single conductive layer. Specifically, in top view, the third electrode 3 may extend outward beyond the region where the functional layer 10 is formed and be connected to the first electrode 1, and the electric contact 15 may be formed as a region of the third electrode 3 outside of the functional layer 10.

The thickness of the electric contact 15 is, for example, greater than or equal to 10 nm and smaller than or equal to 200 nm.

The functional layer 10 is, for example, a composite layer where photoelectric conversion and transport of charges produced by photoelectric conversion take place. The functional layer 10 is, for example, a multi-layer body of coat films formed by a coating method such as spin coating. Note that the composite layer as the functional layer 10 may include a layer formed by a method other than a coating method. Also, the functional layer 10 is not limited to a composite layer and may be formed of a single layer.

In the photoelectric conversion layer 4, hole-electron pairs as excitons are generated by incidence of light. The photoelectric conversion layer 4 contains a photoelectric conversion material that absorbs incident light and generates hole-electron pairs as signal charges. The photoelectric conversion material is, for example, an inorganic semiconductor material or an organic semiconductor material. The photoelectric conversion layer 4 is formed using, for example, a coating method, as will be described later. Thus, for example, a material that dissolves or disperses in a solvent is used as the photoelectric conversion material.

For example, the photoelectric conversion layer 4 contains colloidal quantum dots as the photoelectric conversion material. A colloidal quantum dot is a quantum dot whose surface is modified with a surface modification ligand. The photoelectric conversion layer 4 is formed by, for example, applying a colloidal quantum dot solution to form a film thereof.

A quantum dot is a nanocrystals having a diameter of approximately 2 nm to 10 nm and is formed by approximately several tens to several thousands of atoms. Examples of a material for the quantum dot include a Group-IV semiconductor such as Si or Ge, a Group-IV-VI semiconductor such as PbS, PbSe, or PbTe, a Group-III-V semiconductor such as InAs or InSb, or a ternary mixed crystal such as HgCdTe or PbSnTe.

The photoelectric conversion layer 4 may have a multi-layer structure with two or more quantum dot layers containing quantum dots of different particle sizes from each other. Because the absorption wavelength of a quantum dot varies depending on the particle size, such a configuration allows the photoelectric conversion element 10A to have a wider sensitive wavelength band. Also, for example, when quantum dots having the absorption peak in the near-infrared region are used as the quantum dots, the photoelectric conversion element 10A which is sensitive in the near-infrared region can be achieved.

The surface modification ligand may be any ligand that becomes adsorbed onto the surface of a quantum dot and can be selected from, for example, the ligands described in NPL 1. For example, the energy at the upper end of the valence band of a colloidal quantum dot varies depending on the type of the surface modification ligand. Thus, using a suitable surface modification ligand allows adjustment of the energy band of a colloidal quantum dot.

The surfaces of quantum dots that are available are often modified by a surface modification ligand having long-chain alkyl to increase dispersibility during synthesis. A surface modification ligand having long-chain alkyl hinders migration of charges and is therefore replaced by a surface modification ligand for achieving a desired energy band. Known methods for the replacement are the solid-phase replacement method in which quantum dots are formed into a film (solid phase) and are then exposed to a solution of surface modification ligands as a replacement, to perform replacement using a difference in concentration and a difference in the energy of bonding between ligands and the liquid-phase replacement method in which surface modification ligands are replaced in a solution (liquid phase), and such existing methods can be used.

The thickness of the photoelectric conversion layer 4 is, for example, greater than or equal to 5 nm and smaller than or equal to 1500 nm.

In the present embodiment, of the hole-electron pairs generated in the photoelectric conversion layer 4, the holes are collected by the second electrodes 2, and the electrons are collected by the third electrode 3. In this event, charges with the opposite polarities from the charges collected by the second electrodes 2 and the third electrode 3 may be injected from the second electrodes 2 and the third electrode 3 to the photoelectric conversion layer 4. The charges thus injected from the electrodes cause dark current that flows irrespective of incidence of light on the photoelectric conversion layer 4.

Thus, the photoelectric conversion element 10A according to the present embodiment includes the electron blocking layer 5 between the second electrodes 2 and the photoelectric conversion layer 4, as a charge blocking layer for reducing dark current. The electron blocking layer 5 is a layer to serve as a barrier against electron injection from the second electrodes 2. To reduce dark current due to electron injection from the second electrodes 2, for example, the electron affinity of the electron blocking layer 5 is equivalent to or smaller than that of the photoelectric conversion layer 4. Also, for example, in order not to hinder conduction of holes from the photoelectric conversion layer 4 to the second electrodes 2, the ionization potential of the electron blocking layer 5 is, with the upper limit being a value greater than the ionization potential of the photoelectric conversion layer 4 by 0.5 eV, equivalent to or smaller than the value.

For example, a material for the electron blocking layer 5 is a material satisfying the above-described relations of the electron affinity and the ionization potential and is, for example, a p-type semiconductor. A material for the electron blocking layer 5 is, for example, an organic material such as [N4,N4'-Di (naphthalen-1-yl)-N4,N4'-bis (4-vinylphenyl)biphenyl-4,4'-diamine] (VNPB) or Poly[N,N'-bis(4-butylphenyl)-N,N'bis(phenyl)-benzidine] (poly-TPD). This facilitates removal of the electron blocking layer 5 on the first electrode 1 in the manufacturing process to be described later. A material for the electron blocking layer 5 may also be a metal oxide such as NiO, CoO, Co₃O₄, Cr₂O₃, Cu₂O, or CuO. The electron blocking layer 5 is formed using, for example, a coating method, as will be described later. Thus, for example, a material that dissolves or disperses in a solvent is used as a material for the electron blocking layer 5.

The thickness of the electron blocking layer 5 is, for example, greater than or equal to 5 nm and smaller than or equal to 200 nm.

Also, the photoelectric conversion element 10A according to the present embodiment includes the hole blocking layer 6 as a charge blocking layer between the third electrode 3 and the photoelectric conversion layer 4. The hole blocking layer 6 is a layer to serve as a barrier against hole injection from the third electrode 3. In this case, to reduce dark current caused by hole injection from the third electrode 3, for example, the ionization potential of the hole blocking layer 6 is equivalent to or greater than that of the photoelectric conversion layer 4. Also, for example, in order not to hinder conduction of electrons from the photoelectric conversion layer 4 to the third electrode 3, the electron affinity of the hole blocking layer 6 is equivalent to or greater than that of the photoelectric conversion layer 4.

For example, a material for the hole blocking layer 6 is a material that satisfies the above-described relations of electron affinity and ionization potential and is, for example, an n-type semiconductor. Examples of a material for the hole blocking layer 6 include bathocuproine (BCP), bathophenanthroline (BPhen), fullerenes, zinc oxide, aluminum-doped zinc oxide, titanium oxide, and tin oxide. The hole blocking layer 6 is formed using, for example, a coating method, as will be described later. Thus, for example, a material that dissolves or disperses in a solvent is used as a material for the hole blocking layer 6.

The thickness of the hole blocking layer 6 is, for example, greater than or equal to 5 nm and smaller than or equal to 200 nm.

The electron blocking layer 5 has a hole conduction property to transport holes. Meanwhile, the hole blocking layer 6 has an electron conduction property to transport electrons. Thus, by being in contact with the electron blocking layer 5, the photoelectric conversion layer 4 is electrically connected to the second electrodes 2 via the electron blocking layer 5. Also, by being in contact with the hole blocking layer 6, the photoelectric conversion layer 4 is electrically connected to the third electrode 3 via the hole blocking layer 6.

Note that the functional layer 10 may have only one or neither one of the electron blocking layer 5 and the hole blocking layer 6. Also, in a case where the second electrodes 2 collect electrons, the configuration may be such that the electron blocking layer 5 and the hole blocking layer 6 are switched in position in the photoelectric conversion element 10A. Also, the functional layer 10 may include a layer other than the layers described above. A charge transport layer and a buffer layer are examples of the other layer.

### [Method for Manufacturing the Photoelectric Conversion Element]

Next, a method for manufacturing the photoelectric conversion element 10A according to the present embodiment is described. Note that the manufacturing method described below is an example, and a method for manufacturing the photoelectric conversion element 10A is not limited to the example below.

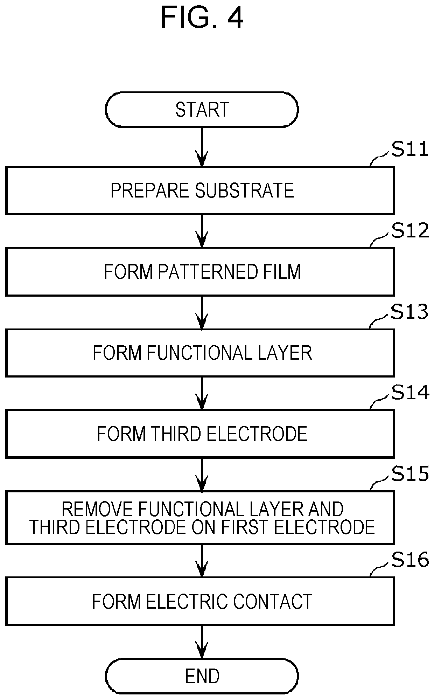

A method for manufacturing the photoelectric conversion element 10A includes a step of preparing the substrate 11 at the upper surface 11a of which the first electrode 1 and the second electrodes 2 are exposed, a step of forming the patterned film 8, a step of forming the functional layer 10, a step of removing a portion of the functional layer 10 that is on the first electrode 1, and a step of forming the electric contact 15. A specific method for manufacturing the photoelectric conversion element 10A is described below using drawings. Fig. 4 is a flowchart of the method for manufacturing the photoelectric conversion element 10A according to the present embodiment.

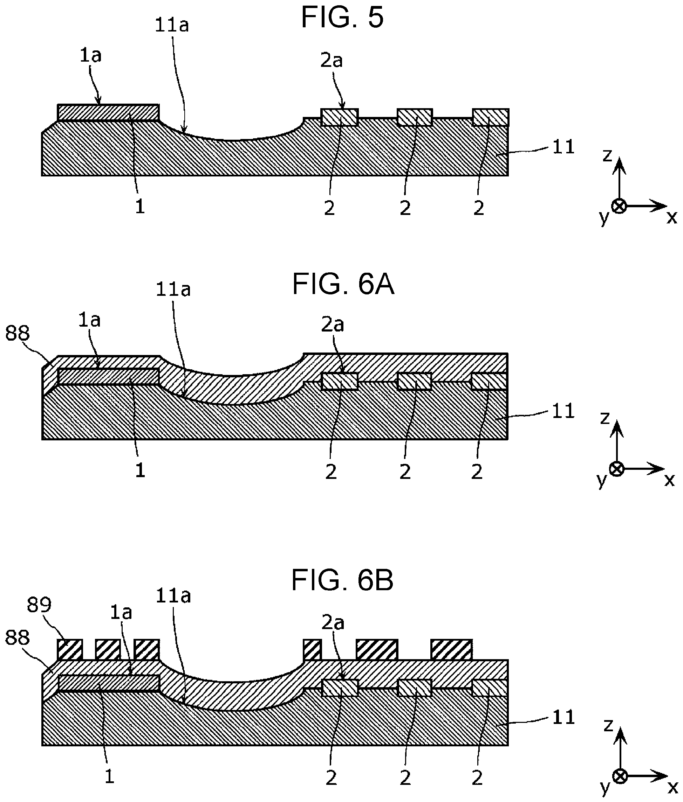

First, as illustrated in Fig. 4, the substrate 11 is prepared (Step S11). Fig. 5 is a diagram illustrating the step of preparing the substrate 11. As illustrated in Fig. 5, specifically, the substrate 11 provided such that the first electrode 1 and the second electrodes 2 are exposed at the upper surface 11a of the substrate 11, is prepared. At the upper side of the substrate 11, the first electrode 1, the second electrodes 2, and the upper surface 11a of the substrate 11 are exposed. A portion of the substrate 11 where the upper surface 11a is formed is, for example, an insulating film such as a TEOS thin film.

For example, the substrate 11 illustrated in Fig. 5 is prepared as follows: the first electrode 1 and the second electrodes 2 are formed at the substrate 11, the entire upper surface of the substrate 11, including the upper surface of the first electrode 1 and the upper surfaces of the second electrodes 2, is covered with a TEOS thin film, and then the surface of the substrate 11 is planarized by CMP (Chemical Mechanical Polishing). As illustrated in Fig. 5, for example, the plurality of second electrodes 2 are formed with a high patterning density. By contrast, the first electrode 1 is formed in isolation with a low patterning density, only at part of a portion outside of the region where the plurality of second electrodes 2 are formed. In a case where CMP is used, the substrate 11 provided with the first electrode 1 and the second electrodes 2 may not become completely planarized due to differences in material between the substrate 11 and the first and second electrodes 1 and 2 and a difference in patterning density between the first electrode 1 and the second electrodes 2. Specifically, after the planarization using CMP, the upper surface 1a of the first electrode 1 and the upper surfaces 2a of the second electrodes 2 are formed at higher positions than the upper surface 11a of the substrate 11 due to a difference between the substrate 11 and the first and second electrodes 1 and 2 in how easily the material is polished. Also, after the planarization using CMP, due to a difference in patterning density between the first electrode 1 and the second electrodes 2, the height of the upper surface 11a of the substrate 11 in the lamination direction is lower around the first electrode 1 than around the second electrodes 2.

The prepared substrate 11 is subjected to, for example, ultrasonic cleaning using a solvent such as acetone or propanol and subsequently to dry cleaning by UV-ozone treatment and is used.

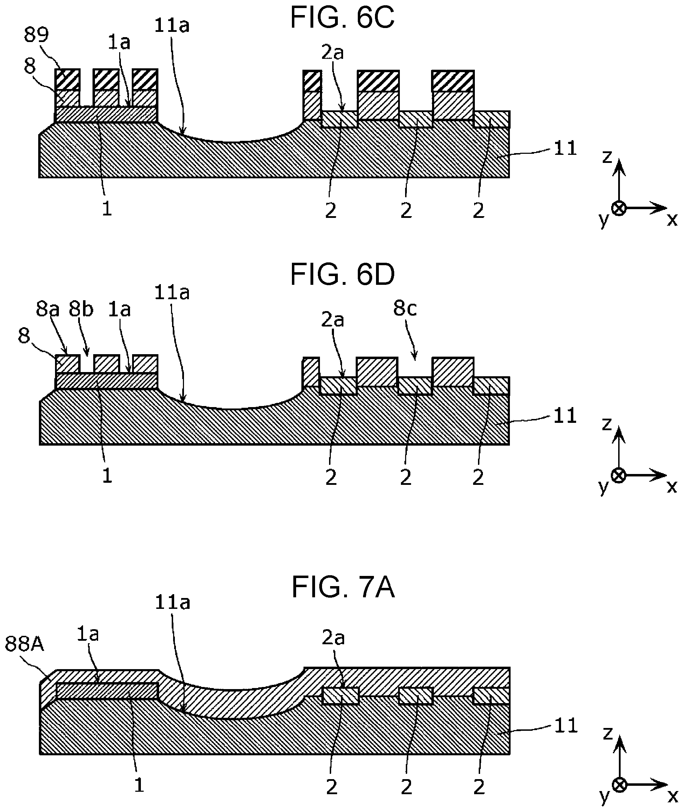

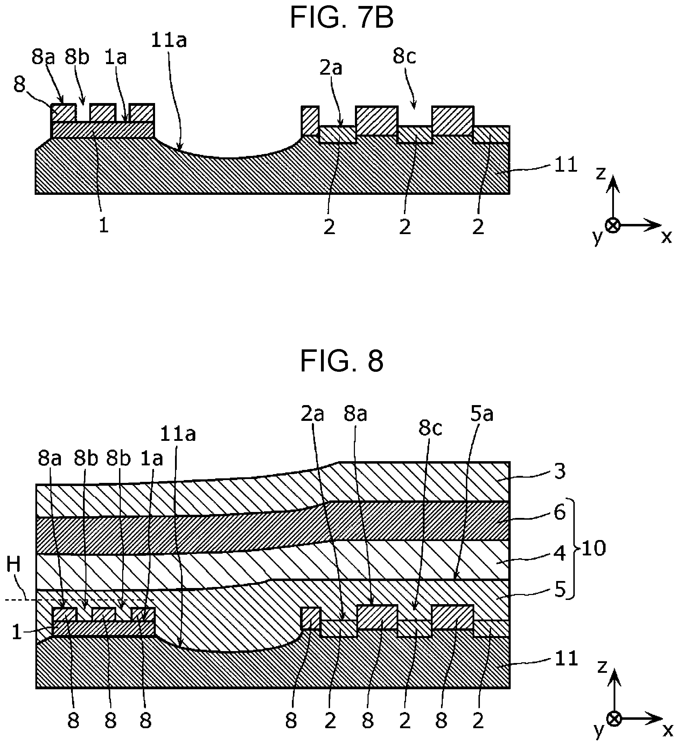

After the substrate 11 is prepared, as illustrated in Fig. 4, the patterned film 8 provided with the gaps 8b is formed above the prepared substrate 11, such that at least part of the upper surface 1a of the first electrode 1 is exposed (Step S12). The step of forming the patterned film 8 is described with reference to Figs. 6A to 6D and Figs. 7A and 7B. Figs. 6A to 6D are diagrams illustrating an example of the step of forming the patterned film 8.

As illustrated in Fig. 6A, first, an un-patterned insulating film 88 is formed on the substrate 11, the first electrode 1, and the second electrodes 2. As a result, the upper surface 11a of the substrate 11, the upper surface 1a of the first electrode 1, and the upper surfaces 2a of the second electrodes 2 are covered by the insulating film 88. The insulating film 88 is, for example, a silicon oxide film. The insulating film 88 is formed using, for example, plasma CVD (Chemical Vapor Deposition). The thickness of the insulating film 88 is, for example, greater than or equal to 1 nm and smaller than or equal to 200 nm. Note that the method for forming the insulating film 88 is not limited to a particular method, and the insulating film 88 may be formed by, for example, spin coating using an SOG (Spin On Glass) material. Also, the insulating film 88 may be a film of a different insulating material such as a silicon nitride film, a tantalum oxide film, or a titanium oxide film.

Next, as illustrated in Fig. 6B, a resist film 89 is formed and patterned on the insulating film 88. For example, an i-line positive photoresist is used for the resist film 89. The resist film 89 is formed by forming a film using, for example, a coating method such as spin coating and patterning the film using photolithography. The thickness of the resist film 89 is, for example, greater than or equal to 50 nm and smaller than or equal to 1000 nm. In top view, the patterns of the removed portions of the resist film 89 correspond to the gaps 8b and the gaps 8c formed in the patterned film 8. Note that not a positive photoresist but a negative photoresist may be used as the resist film 89. Also, lithography is not limited to a method using the i-line, but may be a different method using an electron beam or the like.

Next, as illustrated in Fig. 6C, part of the insulating film 88 is removed by being etched with the resist film 89 used as a mask. This exposes the substrate 11, the first electrode 1, and the second electrodes 2 in regions where the resist film 89 is not provided in top view. The remaining insulating film 88 becomes the patterned film 8. The etching is performed by, for example, plasma etching using a gas such as CF₄ using a RIE (Reactive Ion Etching) apparatus.

Lastly, as illustrated in Fig. 6D, the resist film 89 is removed. The removal of the resist film 89 is performed by, for example, ashing using oxygen plasma and cleaning using a solvent such as acetone.

Also, the patterned film 8 may be formed using a method illustrated in Figs. 7A and 7B. Figs. 7A and 7B are diagrams illustrating another example of the step of forming the patterned film.

As illustrated in Fig. 7A, first, an un-patterned resist film 88A is formed on the substrate 11, the first electrode 1, and the second electrodes 2 of the prepared substrate 11. For example, a negative photoresist is used as a material for the resist film 88A. An epoxy-resin resist may be used as the negative photoresist from the prospective of improving its functionality to protect the first electrode 1. The resist film 88A is formed using, for example, a coating method such as spin coating, and the formed film is heated by pre-baking. Note that a negative electron-beam resist may be used for the resist film 88A.

Next, through exposure and development treatment, the resist film 88A is patterned to have the gaps 8b and the gaps 8c formed therein, and the patterned film 8 is thus formed as illustrated in Fig. 7B. The use of a negative resist material for the patterned film 8 can simplify the step of forming the patterned film 8.

As thus described, using a method such as the two methods described above, the patterned film 8 having the upper surface 8a located at a level above the first electrode 1 and the second electrodes 2 is formed above the substrate 11. Specifically, the patterned film 8 provided with the gaps 8b and the gaps 8c is formed on the substrate 11, the first electrode 1, and the second electrodes 2 prepared in Step S11. Also, for example, the patterned film 8 is formed to cover part of the first electrode 1. Also, for example, the patterned film 8 is formed in any of the top-view shapes illustrated in Figs. 2B to 2D. Also, the patterned film 8 is formed to cover the upper surface 1 1a of the substrate 11 at a region between adjacent ones of the second electrodes 2.

After the patterned film 8 is formed, as illustrated in Fig. 4, the functional layer 10 is formed (Step S13). Next, the third electrode 3 is formed on the functional layer 10 (Step S14). Fig. 8 is a diagram illustrating the step of forming the functional layer 10 and the step of forming the third electrode 3.

As illustrated in Fig. 8, in the formation of the functional layer 10, the electron blocking layer 5, the photoelectric conversion layer 4, and the hole blocking layer 6 are sequentially laminated in this order on the substrate 11, the first electrode 1, the second electrodes 2, and the patterned film 8. First, using a coating method, the electron blocking layer 5 is formed on the substrate 11, the first electrode 1, the second electrodes 2, and the patterned film 8. In the present embodiment, the electron blocking layer 5 is an example of a second film. For example, the electron blocking layer 5 is formed by using spin coating as the coating method. In a case of forming the electron blocking layer 5 using spin coating, when a solution containing a material for the electron blocking layer 5 is spread by spin coating, the thickness of the electron blocking layer 5 tends to be thin on the first electrode 1 because of the unevenness formed at the substrate 11. If the patterned film 8 were not formed, for example, the electron blocking layer 5 might be formed only to the height denoted by broken line H in Fig. 8. Especially when a projecting portion is formed at a region of the substrate 11 where the first electrode 1 is provided like in the example illustrated in the drawing, the height of the upper surface 11a around the first electrode 1 is relatively low in the lamination direction, and the height of the electron blocking layer 5 formed there tends to be low as well. In the present embodiment, the gaps 8b of the patterned film 8 are formed on the first electrode 1, which makes it easier for the solution to fill the gaps 8b and therefore makes the height of the electron blocking layer 5 formed there high relative to the upper surface 1a of the first electrode 1.

Next, using a coating method, the photoelectric conversion layer 4 is formed on the electron blocking layer 5. For example, spin coating is used as the coating method for the formation of the photoelectric conversion layer 4 as well. In a case where colloidal quantum dots are used as the photoelectric conversion material, after the film formation of the photoelectric conversion layer 4, desired surface-modification ligands may be coordinated to quantum dots by ligand exchange. Also, a plurality of quantum dot layers containing quantum dots with different particle sizes from each other may be laminated.

Next, using a coating method, the hole blocking layer 6 is formed on the photoelectric conversion layer 4. For example, spin coating is used as the coating method for the formation of the hole blocking layer 6 as well.

When spin coating is used, the spin speed for the spin coating in the formation of each layer is, for example, greater than or equal to 500 rpm and smaller than or equal to 7000 rpm.

Next, using high-frequency sputtering, the third electrode 3 is formed on the hole blocking layer 6. For example, a TCO film, e.g., an ITO film, is formed as the third electrode 3. As a result of this, as illustrated in Fig. 8, the functional layer 10 and the third electrode 3 are formed on the substrate 11.

Note that at least one of the electron blocking layer 5 and the hole blocking layer 6 does not have to be formed. For example, if the electron blocking layer 5 is not formed, the photoelectric conversion layer 4 is formed on the substrate 11, the first electrode 1, the second electrodes 2, and the patterned film 8, using a coating method. In this case, the photoelectric conversion layer 4 is an example of the second film.

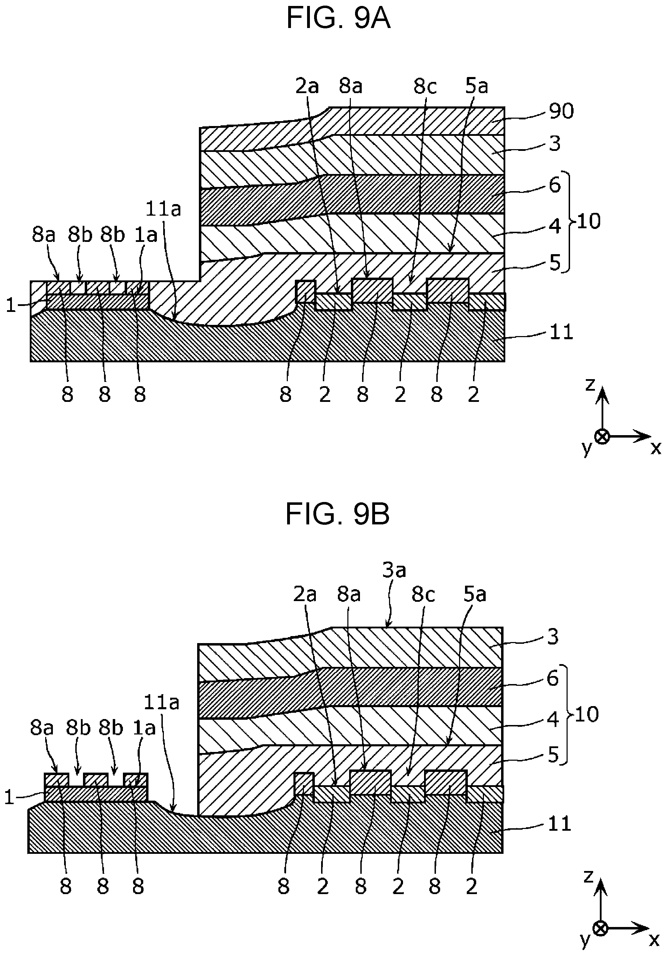

After the functional layer 10 and the third electrode 3 are formed, as illustrated in Fig. 4, the functional layer 30 and the third electrode 3 on the first electrode 1 are removed (Step S15). As a result, a portion of the functional layer 10 that is on the first electrode 1 is removed. Also, the third electrode 3 on the portion of the functional layer 10 to be removed is also removed. Figs. 9A and 9B are diagrams illustrating the step of removing the functional layer 10.

First, a resist film 90 is formed on the third electrode 3 using spin coating or the like, and the resist film 90 is patterned using lithography. For example, as illustrated in Fig. 9A, the patterning is performed so that the resist film 90 may be disposed in a region not overlapping the first electrode 1 but overlapping the second electrodes 2 in top view, i.e., in a region where the functional layer 10 and the third electrode 3 are to be left.

Next, with the resist film 90 used as a mask, part of a portion of the functional layer 10 that is formed on the first electrode 1 is removed by etching. Specifically, in a region including the first electrode 1 but not including the second electrodes 2 in plan view, a portion from the third electrode 3 to part of the electron blocking layer 5, which is the lowermost layer of the functional layer 10, is removed by etching. For example, in a case where colloidal quantum dots are used for the photoelectric conversion layer 4, part of the functional layer 10 is removed by being etched in an NLD (magnetic Neutral Loop Discharge) etching apparatus using a halogen-based gas such as a chlorine-based gas. As a result of the etching, part of a portion of the electron blocking layer 5 that is on the first electrode 1 is left. For example, the etching is done to leave portions of the electron blocking layer 5 that are inside the gaps 8b on the first electrode 1. Note that when the photoelectric conversion layer 4 contains colloidal quantum dots, a halogen-based gas is often used for etching to remove the colloidal quantum dots; however, the gas used for etching is not limited to this. Depending on a material contained in the photoelectric conversion layer 4, a gas (such as, for example, an oxygen-based gas) other than a halogen-based gas may be used for etching.

As described earlier, the thickness of the electron blocking layer 5 on the first electrode 1 is thick because the patterned film 8 is formed. If the patterned film 8 were not formed and the electron blocking layer 5 were consequently thin in thickness, etching with removal power so strong as to possibly remove the first electrode 1, such as etching using a halogen-based gas, might cause over-etching and cause the first electrode 1 to diminish or disappear. For example, if the etching reaches the upper surface 11a of the substrate 11, the first electrode 1 disappears. In the present embodiment, the presence of the thickly-formed electron blocking layer 5 can inhibit the first electrode 1 from diminishing or disappearing due to over-etching.

Also, because the patterned film 8 covers part of the first electrode 1, the patterned film 8 is formed on the first electrode 1, and the electron blocking layer 5 is formed on top of the patterned film 8. This makes it easier for the height of the upper surface 8a of the patterned film 8 to be high and therefore enables the electron blocking layer 5 to be formed more thickly on the first electrode 1. This further inhibits the first electrode 1 from diminishing or disappearing due to over-etching.

Also, for example, as illustrated in Fig. 2B, in a case where the patterned film 8 is provided with the plurality of openings 8b 1, the size of each opening 8b 1 can be reduced, which makes it easier for the electron blocking layer 5 to fill the openings 8b1. This makes the electron blocking layer 5 on the first electrode thicker and further inhibits the first electrode 1 from diminishing or disappearing due to over-etching.

Next, as illustrated in Fig. 9B, remaining part of the electron blocking layer 5 that is unremoved by the above etching is removed using a method, e.g., O₂-RIE, different from the above etching. For example, the electron blocking layer 5 inside the gaps 8b is removed. The resist film 90 is also removed by O₂-RIE. O₂-RIE is performed using, for example, oxygen plasma. As a result, the upper surface 1a of the first electrode 1 and the upper surface 3 a of the third electrode 3 are exposed. The etching thus performed to leave part of the electron blocking layer 5 that is on the first electrode 1 inhibits the first electrode 1 from diminishing or disappearing due to over-etching. Also, the steps can be simplified by performing the removal of the resist film 90 at the same time.

After the functional layer 10 formed on the first electrode 1 is removed, as illustrated in Fig. 4, the electric contact 15 is formed on the first electrode 1 (Step S16). Fig. 10 is a diagram illustrating the step of forming the electric contact 15.

As illustrated in Fig. 10, the electric contact 15 is formed to be connected to the upper surface 1a of the first electrode 1 and the upper surface 3a of the third electrode 3. The electric contact 15 electrically connects the first electrode 1 and the third electrode 3. The electric contact 15 is formed using, for example, high-frequency sputtering. For example, a TCO film, e.g., an ITO film, is formed as the electric contact 15. A metal film may be formed as the electric contact 15. In this case, the electric contact 15 may be formed using vapor deposition. After that, the electric contact 15 in an unnecessary region is removed as needed using lithography, etching, and the like, and as a result, the photoelectric conversion element 10A illustrated in Fig. 1 is obtained. Note that Step S14 may be omitted, and the electric contact 15 and the third electrode 3 may be formed as a single conductive layer in Step S16.

Further, a protective layer formed of SiON, AlO, or the like may be formed on the photoelectric conversion element 10A as needed. Then, lithography and etching may be performed to expose a pad electrode and the like for connection.

As described above, the method for manufacturing the photoelectric conversion element 10A according to the present embodiment includes the steps of preparing the substrate 11 at the upper surface 11a of which the first electrode 1 and the second electrodes 2 are exposed, forming the patterned film 8 provided with the gaps 8b where at least part of the upper surface 1a of the first electrode 1 is exposed in top view, forming the electron blocking layer 5 on the first electrode 1, the second electrodes 2, and the patterned film 8 using a coating method, removing a portion of the electron blocking layer 5 that is on the first electrode 1, and forming the electric contact 15 on the first electrode 1.

The surface of the substrate 11 is subjected to planarization using, for example, CMP, but the surface of the substrate 11 tends to be uneven due to a difference in material between the substrate 11 and the first and second electrodes 1 and 2 and a difference in patterning density between the first electrode 1 and the second electrodes 2. Specifically, the first electrode 1 tends to project more than the insulating layer of the substrate 11 present around the first electrode 1. When films are formed on the substrate 11 using a coating method in order to form the functional layer 10, the film thicknesses of the layers formed at the projecting portion are thin. In other words, the film thicknesses of the layers formed on the first electrode 1 tend to be thin. If the functional layer 10 on the first electrode 1 is etched for removal of the functional layer 10 without the patterned film 8 being formed, the first electrode 1 is exposed before the substrate 11, which can lead to excessive etching of the first electrode 1. As a result, the first electrode 1 diminishes, or in some cases, the first electrode 1 disappears. This may result in a defective product where control voltage cannot be applied even if the electric contact 15 is formed in a region where the functional layer 10 has been removed. This means lower yield. Also, even in a case where the first electrode 1 projects less than the insulating layer of the substrate 11, yield lowers if etching is performed excessively.

In this regard, in the manufacturing method according to the present embodiment, because the patterned film 8 provided with the gaps 8b is formed on the first electrode 1, the electron blocking layer 5 formed using a coating method fills the gaps 8b on the first electrode 1 and becomes thick. This reduces a possibility that, in the step of removing the portion of the electron blocking layer 5 that is on the first electrode, the first electrode is removed and the first electrode 1 diminishes or disappears. This in turn reduces a connection failure between the first electrode 1 and the electric contact 15. This can improve yield of the photoelectric conversion element 10A manufactured.

### [Modification]

Next, a modification of the photoelectric conversion element 10A described above is described. The following describes mainly differences from the embodiment and omits or simplifies descriptions that are common to the embodiment.

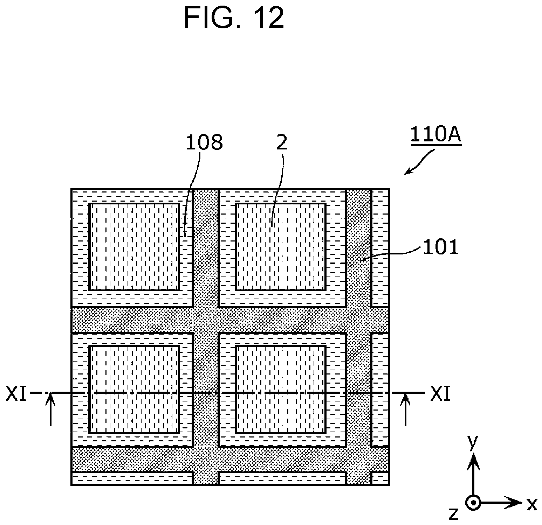

Fig. 11 is a sectional view of a photoelectric conversion element 110A according to the present modification. Fig. 12 is a top perspective view of the photoelectric conversion element 110A according to the present modification. Fig. 11 illustrates a section taken along line XI-XI in Fig. 12. Also, part of the photoelectric conversion element 110A is illustrated in Figs. 11 and 12. Specifically, Figs. 11 and 12 are diagrams illustrating part of a region where the plurality of second electrodes 2 are arranged on the substrate 11. Also, Fig. 12 omits depiction of the functional layer 10, the third electrode 3, and the electric contact 15. In other words, Fig. 12 is a diagram illustrating a planar layout of a first electrode 101, the second electrodes 2, and patterned films 108, transparently through the functional layer 10, the third electrode 3, and the electric contact 15.

The photoelectric conversion element 110A illustrated in Fig. 11 differs from the photoelectric conversion element 10A illustrated in Fig. 1 mainly in including the first electrode 101 and the patterned films 108 in place of the first electrode 1 and the patterned film 8. The first electrode 101 and the patterned films 108 are different from the first electrode 1 and the patterned film 8 in their shapes and positions at which they are disposed on the substrate 11.

As illustrated in Figs. 11 and 12, the first electrode 101 is disposed in between the plurality of second electrodes 2 arranged in rows and columns in top view. Specifically, in top view, the first electrode 101 is disposed in between adjacent ones of the second electrodes 2. The first electrode 101 is, for example, in the shape of a grid in top view. Also, the first electrode 101 and the second electrodes 2 are spaced away from each other, and the insulating layer of the substrate 11 is disposed between the first electrode 101 and the second electrodes 2. The width of the first electrode 101 is, for example, shorter than that of the second electrodes 2.

The patterned films 108 are an example of the first film. The patterned films 108 are located above the substrate 11. Upper surfaces 108a of the patterned films 108 are located at a level above the first electrode 101 and the second electrodes 2.

The patterned films 108 are disposed to sandwich the first electrode 101 without interposition of the second electrodes 2 in top view, thereby providing a gap 108b overlapping at least part of an upper surface 101a of the first electrode 101. In top view, the gap 108b does not overlap the upper surfaces 2a of the second electrodes 2. The gap 108b is, for example, in the shape of a grid in top view.

Also, the first electrode 101 is disposed between adjacent ones of the second electrodes 2, and the patterned film 108 is, by being disposed to sandwich the first electrode 101 without interposition of the second electrode 2 in top view, disposed between the first electrode 101 and the second electrode 2 and between adjacent ones of the second electrodes 2. The patterned film 108 is disposed, for example, annularly in top view, surrounding each first electrode 101 independently. With such an arrangement, the patterned films 108 forming the gap 108b inhibit the first electrode 101 from diminishing or disappearing and also reduce charge migration between adjacent ones of the second electrodes 2. Also, because the first electrode 101 is disposed between adjacent ones of the second electrodes 2, the distance between the first electrode 101 and the second electrode 2 is short, which makes it easier for charge migration to occur due to a potential difference between the first electrode 101 and the second electrode 2. Especially because a bias voltage to be applied between the second electrodes 2 and the third electrode 3 is fed to the first electrode 101, the potential difference between the first electrode 101 and the second electrodes 2 tends to be large. The disposition of the patterned film 108 between the first electrode 101 and the second electrode 2 also reduces charge migration between the first electrode 101 and the second electrode 2.

Also, as illustrated in Fig. 11, the photoelectric conversion element 110A has the functional layer 10 separately for each of the plurality of second electrodes 2. In other words, in top view, a plurality of functional layers 10 are disposed for the respective second electrodes 2 at positions overlapping the plurality of second electrodes and are spaced away from each other. This physically reduces charge migration between adjacent ones of the second electrodes 2 via the functional layer 10. Also, in a case where a transparent electrode material or the like which typically has a higher resistance value than a metal material is used for the electric contact 15 and the third electrode 3, characteristics may lower depending on how high the resistance value is, because in a case where such a transparent electrode material is used in an imaging device, upon application of a voltage to the photoelectric conversion layer 4, an afterimage may be generated or voltage pulses applied to the electric contact 15 may be distorted in a global shutter operation. Forming the first electrode 101 with metal wiring and connecting the first electrode 101 disposed between the second electrodes 2 to the electric contact 15 makes the distance of the electric contact 15 short and enables the resistance to be lower, and in turn, reduces degradation of the characteristics of an imaging device.

In the photoelectric conversion element 110A, the electric contact 15 is connected to the first electrode 101 through the gap 108b.

The photoelectric conversion element 110A can also be manufactured by changing the above-described method for manufacturing the photoelectric conversion element 10A to the arrangement of the first electrode 101 and the patterning of the patterned films 108. In the manufacturing process, the patterned films 108 make the electron blocking layer 5 formed on the first electrode 101 thick and thereby inhibits the first electrode 101 from diminishing or disappearing as a result of the above-described etching. Thus, yield of the photoelectric conversion element 110A can be improved.

### [Imaging Device]

Next, an imaging device according to the present embodiment is described.

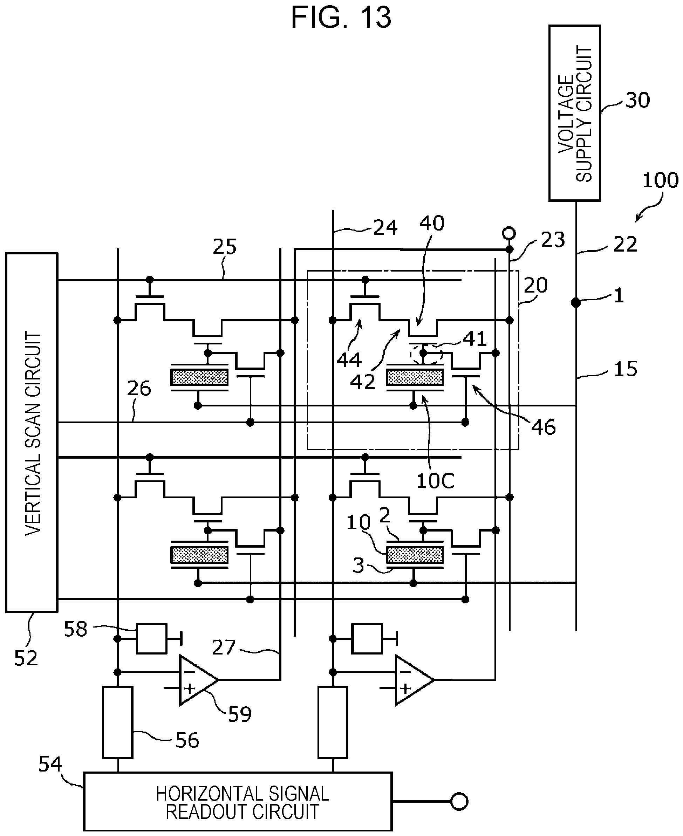

First, an overall configuration of the imaging device according to the present embodiment is described. The imaging device according to the present embodiment has a configuration having a signal detection circuit, peripheral circuits, and the like in addition to the configuration of the photoelectric conversion element 10A described above. Although the following describes an imaging device having the configuration of the photoelectric conversion element 10A, the imaging device may have the configuration of the photoelectric conversion element 110A. Fig. 13 is a diagram illustrating an example circuit configuration of an imaging device 100 according to the present embodiment. The imaging device 100 illustrated in Fig. 13 has a plurality of pixels 20 and peripheral circuits. The plurality of pixels 20 and the peripheral circuits are formed at, for example, the substrate 11. The peripheral circuits include a voltage supply circuit 30 that supplies a predetermined voltage to each of the pixels 20.

The pixels 20 are disposed at the substrate 11 one-dimensionally or two-dimensionally, forming a photosensitive region, i.e., a pixel region. In the configuration exemplified in Fig. 13, the pixels 20 are arranged in the row direction and in the column direction. The row direction and the column direction herein mean a direction in which a row extends and a direction in which a column extends, respectively. Thus, on the paper plane of Fig. 13, the longitudinal direction is the column direction, and the lateral direction is the row direction. Fig. 13 illustrates four pixels 20 disposed in a matrix of 2 × 2. The number of pixels 20 illustrated in Fig. 13 is merely an example provided for the sake of description, and the number of pixels 20 is not limited to four.

The plurality of pixels 20 each have a photoelectric converter 10C and a signal detection circuit 40 that detects a signal generated by the photoelectric converter 10C. The signal detection circuit 40 is an example of a signal readout circuit. The photoelectric converter 10C includes the second electrode 2, the third electrode 3, and the functional layer 10 disposed between them. The second electrode 2 functions as a charge collector. The signal detection circuit 40 is connected to the second electrode 2. The third electrode 3 is connected to the voltage supply circuit 30 via a storage control line 22. The storage control line 22 includes, as part thereof, the first electrode 1 and the electric contact 15 described above. When the imaging device 100 operates, a predetermined bias voltage is applied to the third electrodes 3 via the storage control line 22. In the present embodiment, the second electrode 2 is a pixel electrode that collects signal charges, and the third electrode 3 is an opposite electrode opposing the pixel electrode.

The photoelectric converter 10C is configured such that the second electrode 2 collects holes (in other words, positive charges) as signal charges out of electron-hole pairs generated by photoelectric conversion. Holes can be collected by the second electrode 2 when the potential of the third electrode 3 is controlled using the bias voltage generated by the voltage supply circuit 30. The voltage supply circuit 30 supplies voltage to the third electrode 3 via the storage control line 22 so that the third electrode 3 may be a positive potential relative to the second electrode 2. Specifically, a voltage of, for example, approximately 10 V is applied to the storage control line 22 so that a potential may be higher at the third electrode 3 than at the second electrode 2. Note that in a case where the second electrode 2 collects electrons, the voltage supply circuit 30 supplies a voltage to the third electrode 3 via the storage control line 22 so that the third electrode 3 may be a negative potential relative to the second electrode 2.

In the configuration exemplified in Fig. 13, the signal detection circuit 40 includes an amplification transistor 42, an address transistor 44, and a reset transistor 46. The amplification transistor 42 is also called a charge detection transistor, and the address transistor 44 is also called a row selection transistor. The amplification transistor 42 and the address transistor 44 are, for example, field-effect transistors (FETs) formed at the semiconductor layer of the substrate 11. The following describes an example of using N-channel MOSFETs (Metal Oxide Semiconductor Field Effect Transistors) as transistors, unless otherwise noted. The semiconductor layer of the substrate 11 is, for example, a p-type silicon layer. The amplification transistor 42, the address transistor 44, and the reset transistor 46 each have a control terminal, an input terminal, and an output terminal. The control terminal is, for example, a gate. The input terminal is one of a drain and a source and is, for example, a drain. The output terminal is the other one of a drain and a source and is, for example, a source.

As illustrated in Fig. 13, one of the input terminal and the output terminal of the amplification transistor 42 is connected to one of the input terminal and the output terminal of the address transistor 44. The control terminal of the amplification transistor 42 is electrically connected to the second electrode 2 of the photoelectric converter 10C. Signal charges collected by the second electrode 2 are stored at a charge storage node 41 between the second electrode 2 and the gate of the amplification transistor 42. The charge storage node 41 is an example of a charge storage component and also called a "floating diffusion node".

A voltage in accordance with the signal charges stored at the charge storage node 41 is applied to the gate of the amplification transistor 42. The amplification transistor 42 amplifies this voltage. More specifically, the amplification transistor 42 amplifies a signal generated by the photoelectric converter 10C. The voltage amplified by the amplification transistor 42 is selectively read out as a signal voltage via the address transistor 44.

One of the source and the drain of the reset transistor 46 is connected to the charge storage node 41, and one of the source and the drain of the reset transistor 46 has electrical connection to the second electrode 2.

The reset transistor 46 resets signal charges stored at the charge storage node 41. In other words, the reset transistor 46 resets the potentials of the gate of the amplification transistor 42 and the second electrode 2.

As illustrated in Fig. 13, the imaging device 100 includes power supply lines 23, vertical signal lines 24, address signal lines 25, and reset signal lines 26. These lines are connected to each of the pixels 20. The power supply line 23 is connected to one of the source and the drain of the amplification transistor 42 and supplies a predetermined power supply voltage to the pixel 20. The power supply line 23 functions as a source-follower power supply. The vertical signal line 24 is connected to one of the source and the drain of the address transistor 44, the one being not connected to the source or the drain of the amplification transistor 42. The address signal line 25 is connected to the gate of the address transistor 44. The reset signal line 26 is connected to the gate of the reset transistor 46.

The peripheral circuits of the imaging device 100 include a vertical scan circuit 52, a horizontal signal readout circuit 54, a plurality of column signal processing circuits 56, a plurality of load circuits 58, and a plurality of inverting amplifiers 59. The vertical scan circuit 52 is also called a "row scan circuit", the horizontal signal readout circuit 54 is also called a "column scan circuit", and the column signal processing circuit 56 is also called a "row signal storage circuit". The column signal processing circuit 56, the load circuit 58, and the inverting amplifier 59 are provided for each corresponding column of the plurality of pixels 20 arranged in the row direction and in the column direction. Each of the column signal processing circuits 56 is electrically connected to the pixels 20 disposed on the corresponding column via a corresponding one of the vertical signal lines 24 for the respective columns of the plurality of pixels 20. The plurality of column signal processing circuits 56 are electrically connected to the horizontal signal readout circuit 54. Each of the load circuits 58 is electrically connected to a corresponding one of the vertical signal lines 24, and the load circuit 58 and the amplification transistor 42 form a source-follower circuit.

The vertical scan circuit 52 is connected to the address signal lines 25 and the reset signal lines 26. The vertical scan circuit 52 applies a row selection signal for controlling on and off of the address transistor 44 to the gate of the address transistor 44 via the address signal line 25. The row selection signal is sent for each address signal line 25, thereby scanning and selecting a row to be read out. A signal voltage is read out from the selected row of pixels 20 to the vertical signal line 24. Also, the vertical scan circuit 52 applies a reset signal for controlling on and off of the reset transistor 46 to the gate of the reset transistor 46 via the reset signal line 26. A row selection signal is sent to each of the reset signal lines 26, thereby selecting the row of pixels 20 targeted for a reset operation. In this way, the vertical scan circuit 52 selects the plurality of pixels 20 on a row-by-row basis and performs readout of signal voltages and reset of the potentials of the second electrodes 2.

The signal voltages read out from the pixels 20 selected by the vertical scan circuit 52 are sent to the column signal processing circuit 56 via the vertical signal line 24. The column signal processing circuit 56 performs noise reduction signal processing typified by correlated double sampling, analog-to-digital conversion (AD conversion), and the like. The horizontal signal readout circuit 54 sequentially reads out signals from the plurality of column signal processing circuits 56 to a horizontal common signal line (not shown).

Note that the vertical scan circuit 52 may include, as part thereof, the voltage supply circuit 30 described earlier. Alternatively, the voltage supply circuit 30 may have electrical connection to the vertical scan circuit 52. In other words, the bias voltage may be applied to the third electrode 3 via the vertical scan circuit 52.

In the configuration exemplified in Fig. 13, the plurality of inverting amplifiers 59 are provided in correspondence to the respective columns. The negative-side input terminal of each inverting amplifier 59 is connected to the corresponding vertical signal line 24. The output terminal of the inverting amplifier 59 is connected to the pixels 20 of the corresponding column via a corresponding one of feedback lines 27 provided for the respective columns.

As illustrated in Fig. 13, the feedback line 27 is connected to one of the source and the drain of the reset transistor 46, the one (e.g., the drain) being not connected to the charge storage node 41. Thus, the inverting amplifier 59 receives, at its negative terminal, an output from the address transistor 44 when the address transistor 44 and the reset transistor 46 are electrically continuous. Meanwhile, a reference voltage for reset is applied from a power supply (not shown) to the positive-side input terminal of the inverting amplifier 59. The inverting amplifier 59 performs a feedback operation so that the gate voltage of the amplification transistor 42 may be a predetermined feedback voltage. A feedback voltage means a voltage outputted from the inverting amplifier 59. The voltage outputted from the inverting amplifier 59 is, for example, 0 V or a positive voltage near 0 V. The inverting amplifier 59 may be called a "feedback amplifier".

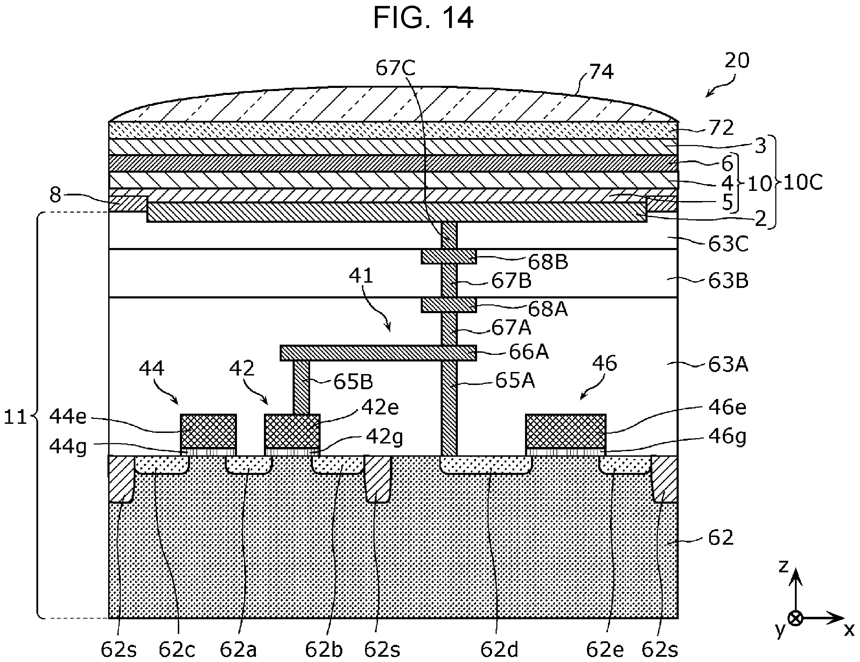

Fig. 14 is a sectional view schematically illustrating the device structure of the pixel 20 in the imaging device 100 according to the present embodiment. In the imaging device 100, the pixels 20 with the structure illustrated in Fig. 14 are arranged in rows and columns in top view. In the configuration exemplified in Fig. 14, the pixel 20 includes the configuration of a region of the photoelectric conversion element 10A where the plurality of second electrodes 2 are formed. For example, the pixel 20 includes the substrate 11 that supports the photoelectric converter 10C. The substrate 11 includes a semiconductor layer 62 and interlayer insulating layers 63A, 63B, and 63C. As illustrated in Fig. 14, the photoelectric converter 10C is disposed above the substrate 11. In the imaging device 100, light falls incident on the photoelectric converter 10C from above the photoelectric converter 10C. In this example, the interlayer insulating layers 63A, 63B, and 63C are laminated on the semiconductor layer 62, and the second electrodes 2, the electron blocking layer 5, the photoelectric conversion layer 4, the hole blocking layer 6, and the third electrode 3 are disposed in this order on the interlayer insulating layer 63C. The second electrodes 2 are partitioned for the respective pixels. Because the second electrodes 2 are formed in such a manner as to be spatially separated from each other between adjacent two pixels 20, the adjacent two second electrodes 2 are electrically isolated from each other. Also, the patterned film 8 is disposed between the adjacent two second electrodes 2. Also, the functional layer 10 and the third electrode 3 may be formed in such a manner as to extend over the plurality of pixels 20.

The amplification transistor 42, the address transistor 44, and the reset transistor 46 are formed on the semiconductor layer 62.

The amplification transistor 42 includes impurity regions 62a and 62b formed at the semiconductor layer 62, a gate insulating layer 42g located on the semiconductor layer 62, and a gate electrode 42e located on the gate insulating layer 42g. The impurity regions 62a and 62b function as the drain or source of the amplification transistor 42. The impurity regions 62a and 62b and impurity regions 62c, 62d, and 62e to be described later are, for example, n-type impurity regions.

The address transistor 44 includes the impurity regions 62a and 62c formed at the semiconductor layer 62, a gate insulating layer 44g located on the semiconductor layer 62, and a gate electrode 44e located on the gate insulating layer 44g. The impurity regions 62a and 62c function as the drain or source of the address transistor 44. In this example, the amplification transistor 42 and the address transistor 44 share the impurity region 62a, and thus the source (or drain) of the amplification transistor 42 and the drain (or source) of the address transistor 44 are electrically connected.

The reset transistor 46 includes the impurity regions 62d and 62e formed in the semiconductor layer 62, a gate insulating layer 46g located on the semiconductor layer 62, and a gate electrode 46e located on the gate insulating layer 46g. The impurity regions 62d and 62e function as the drain or source of the reset transistor 46.

In the semiconductor layer 62, a device isolation region 62s is provided between the pixels 20 that are adjacent to each other and between the amplification transistor 42 and the reset transistor 46. The device isolation region 62s electrically isolates the pixels 20 that are adjacent to each other. Also, the provision of the device isolation region 62s between the pixels 20 adjacent to each other reduces leakage of signal charges stored at the charge storage node 41.

Formed in the interlayer insulating layer 63A are a contact plug 65A connected to the impurity region 62d of the reset transistor 46, a contact plug 65B connected to the gate electrode 42e of the amplification transistor 42, and wiring 66A that connects the contact plug 65A and the contact plug 65B. Thereby, the impurity region 62d (e.g., the drain) of the reset transistor 46 is electrically connected to the gate electrode 42e of the amplification transistor 42. In the configuration exemplified in Fig. 14, a plug 67A and wiring 68A are also formed in the interlayer insulating layer 63A. Also, a plug 67B and wiring 68B are formed in the interlayer insulating layer 63B, and a plug 67C is formed in the interlayer insulating layer 63C; thus, the wiring 66A and the second electrodes 2 are electrically connected. The contact plug 65A, the contact plug 65B, the wiring 66A, the plug 67A, the wiring 68A, the plug 67B, the wiring 68B, and the plug 67C are formed of, for example, metal.

In the configuration exemplified in Fig. 14, a protective layer 72 is disposed on the third electrode 3. The protective layer 72 is not a substrate disposed to support the photoelectric converter 10C. The protective layer 72 is a layer for protecting the photoelectric converter 10C and insulating the photoelectric converter 10C from others. The protective layer 72 may have a high light-transmitting property for wavelengths absorbed by the photoelectric conversion layer 4. A material for the protective layer 72 may be any insulator with a light-transmitting property and is, for example, SiON, AlO, or the like. As illustrated in Fig. 14, a microlens 74 may be disposed on the protective layer 72.

The imaging device 100 described above can be manufactured using the method for manufacturing the photoelectric conversion element 10A described above and a typical semiconductor manufacturing process. For example, in a case where a silicon semiconductor is used as the semiconductor layer 62, the substrate 11 and the circuits can be manufactured using various silicon semiconductor processes.

### (Other Embodiments)

The photoelectric conversion element and the imaging device according to the present disclosure are described above based on the embodiment and the modification, but the present disclosure is not limited to these embodiment and modification. The scope of the present disclosure also includes other modes obtained by applying various modifications conceived of by those skilled in the art to the embodiment or the modification or other modes obtained by combining some of the constituents of the embodiment and the modification, unless such modes depart from the gist of the present disclosure.

For example, the photoelectric conversion element according to the present disclosure may be used for a solar cell in such a way that charges generated by light are taken as energy. Also, the photoelectric conversion element according to the present disclosure may be used for an optical sensor in such a way that charges generated by light are taken as a signal. Also, the photoelectric conversion layer may be replaced by a different functional film to be used as a functional element different from the photoelectric conversion element. As the functional element according to the present disclosure, for example, a light emitting element having a functional layer including a light emitting layer may be implemented.

Also, although the substrate provided with the first electrode and the second electrodes has formation of unevenness in the embodiment described above, the upper surface of the substrate, the upper surface of the first electrode, and the upper surfaces of the second electrodes may be substantially flush with one another.

Also, although spin coating is used as a coating method in the formation of the layers of the functional layer in the embodiment described above, the present disclosure is not limited to this. The coating method may be other methods such as an inkjet method, a spray method, a screen printing method, or a gravure printing method.

### Industrial Applicability

The functional element such as the photoelectric conversion element and the imaging device according to the present disclosure can be used for various purposes, such as a solar cell, a photodiode, and an image sensor.

### Reference Signs List

1, 101 first electrode
1a, 2a, 3a, 5a, 8a, 11a, 101a, 108a upper surface
1s, 8b2, 8b3 slit
1sa region
2 second electrode
3 third electrode
4 photoelectric conversion layer
5 electron blocking layer
6 hole blocking layer
8, 108 patterned film
8b, 8c, 108b gap
8b1 opening
10 functional layer
10A, 110A photoelectric conversion element
10C photoelectric converter
11 substrate
15 electric contact
20 pixel
22 storage control line
23 power supply line
24 vertical signal line
25 address signal line
26 reset signal line
27 feedback line
30 voltage supply circuit
40 signal detection circuit
41 charge storage node
42 amplification transistor
42e, 44e, 46e gate electrode
42g, 44g, 46g gate insulating layer
44 address transistor
46 reset transistor
52 vertical scan circuit
54 horizontal signal readout circuit
56 column signal processing circuit
58 load circuit
59 inverting amplifier
62 semiconductor layer
62a, 62b, 62c, 62d, 62e impurity region
62s device isolation region
63A, 63B, 63C interlayer insulating layer
65A, 65B contact plug
66A wiring
67A, 67B, 67C plug
68A, 68B wiring
72 protective layer
74 microlens
88 insulating film
88A, 89, 90 resist film
100 imaging device

## Claims

1. A method for manufacturing a functional element, the method comprising:
preparing a substrate at an upper surface of which a first electrode and a second electrode are exposed;
forming a first film above the substrate, the first film being provided with a gap where at least part of an upper surface of the first electrode is exposed;
forming a second film on the first electrode, the second electrode, and the first film using a coating method;
exposing the at least part of the upper surface of the first electrode by removing a portion of the second film that is on the first electrode; and
forming an electric contact on the first electrode.

2. The method for manufacturing a functional element according to claim 1, wherein
the coating method is spin coating.

3. The method for manufacturing a functional element according to claim 1 or 2, wherein
in the forming of the first film, the first film is formed to cover part of the first electrode.

4. The method for manufacturing a functional element according to any one of claims 1 to 3, wherein
the gap is at least one opening.

5. The method for manufacturing a functional element according to claim 4, wherein the at least one opening includes a plurality of openings.

6. The method for manufacturing a functional element according to any one of claims 1 to 5, wherein
the removing of the portion of the second film that is on the first electrode includes removing the portion of the second film by etching using a halogen-based gas.

7. The method for manufacturing a functional element according to any one of claims 1 to 6, wherein
the portion of the second film that is on the first electrode includes a first portion and a second portion, and
the removing of the portion of the second film that is on the first electrode includes removing the first portion and removing the second portion unremoved in the removing of the first portion.

8. A functional element comprising:
a substrate;
a first electrode provided at an upper surface of the substrate;
at least one second electrode provided at the upper surface of the substrate;
a first film located above the substrate and provided with a gap overlapping at least part of an upper surface of the first electrode in top view;
a functional layer located on the at least one second electrode;
a third electrode located on the functional layer; and
an electric contact connected to the first electrode through the gap of the first film and electrically connecting the first electrode and the third electrode, wherein
a height of a surface of the first film from the upper surface of the substrate is lower than a height of a surface of the functional film from the upper surface of the substrate.

9. The functional element according to claim 8, wherein
the first film covers part of the first electrode.

10. The functional element according to claim 8 or 9, wherein
the gap is at least one opening.

11. The functional element according to claim 10, wherein
the at least one opening includes a plurality of openings.

12. The functional element according to any one of claims 8 to 11, wherein
the functional element is a photoelectric conversion element, and
the functional layer includes a photoelectric conversion layer.

13. The functional element according to any one of claims 8 to 11, wherein
the functional element is an imaging device,
the at least one second electrode includes a plurality of second electrodes,
the functional layer includes a photoelectric conversion layer, and
the plurality of second electrodes are a plurality of pixel electrodes spaced away from one another.

14. The functional element according to claim 13, wherein
the first film covers the upper surface of the substrate at a region between two adjacent pixel electrodes of the plurality of pixel electrodes.

15. The functional element according to any one of claims 12 to 14, wherein
the photoelectric conversion layer contains a colloidal quantum dot.
